(19) Europäisches Patentamt
European Patent Office
Office européen des brevets

(11) **EP 1 235 473 B1**

(12) **EUROPEAN PATENT SPECIFICATION**

(45) Date of publication and mention
of the grant of the patent:
**31.12.2008   Bulletin 2009/01**

(51) Int Cl.:
*H05K 9/00* *(2006.01)*   *C08J 9/00* *(2006.01)*
*B29C 44/00* *(2006.01)*   *C09K 3/10* *(2006.01)*

(21) Application number: **01301793.4**

(22) Date of filing: **27.02.2001**

(54) **Gasket material for shielding electromagnetic waves and method for producing same**

Dichtungsmaterial zum Schutz gegen elektromagnetische Wellen und Verfahren zu dessen Herstellung

Matériau pour joint électromagnétique et sa méthode de fabrication

(84) Designated Contracting States:
**FI FR IT**

(43) Date of publication of application:
**28.08.2002   Bulletin 2002/35**

(73) Proprietor: **SEIREN CO., LTD.**
**Fukui-shi,**
**Fukui-ken (JP)**

(72) Inventors:
• **Shioda, Seiji**
**Fukui-shi,**
**Fukui 910 (JP)**
• **Kishimoto, Hiroo**
**Takefu-shi,**
**Fukui 915 (JP)**

• **Katayama, Akihide**
**Fukui-shi,**
**Fukui 910 (JP)**
• **Hirano, Yoshiyuki**
**Fukui-shi,**
**Fukui 910 (JP)**

(74) Representative: **Hamer, Christopher K. et al**
**Mathys & Squire LLP**
**120 Holborn**
**London**
**EC1N 2SQ (GB)**

(56) References cited:
**EP-A- 0 403 112      EP-A- 0 917 419**
**WO-A-00/23513      DE-A- 19 737 685**
**US-A- 4 857 668**

**Description**

Field of the Invention

The present invention relates to an electrically conductive material (simply "conductive material" hereinafter) suitable for a gasket material for shielding electromagnetic waves leaking mainly from electronic devices and equipment or entering such devices and equipment from the exterior, as well a method for producing the conductive material.

Background of the Invention

In recent years, electronic devices such as personal computers, television games, and portable telephone have come into wide use, even in general home life. With the extension of application of such electronic devices from industrial applications to home applications, problems have come to occur frequently such as malfunction of other electronic devices caused by electromagnetic waves leaking from the electronic devices in question or radio wave interference of communication equipment caused by the leaking electromagnetic waves. Such problems have come to be taken up as serious matters also in the mass media.

In such a social environment, in the electronics and related industries there is a great demand for an electromagnetic wave shielding material which exhibits an excellent shielding effect for preventing the occurrence of various troubles caused by electromagnetic waves leaking from such electronic devices as referred to above.

Generally, among electromagnetic waves generated from devices which utilize electronics, particularly those leaking from joints of component parts which constitute a housing of such an electronic device, as well as those leaking from gaps of an opening/closing door attached to the said housing, bring a serious problem. For the purpose of shielding such leaking electromagnetic waves there have been proposed various forms of gasket materials.

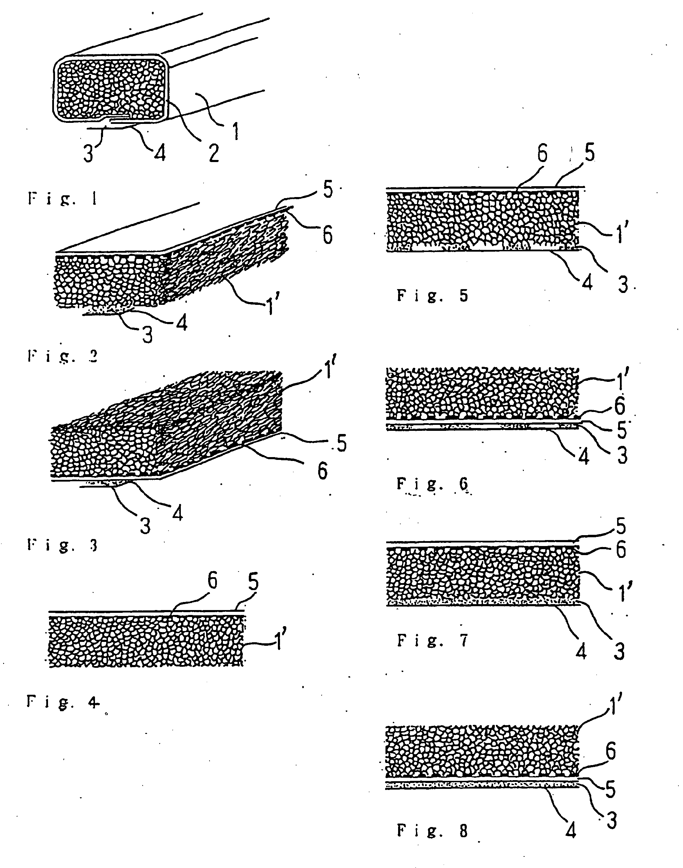

As shielding materials of a structure capable of satisfying the above shielding purpose, gasket products having compression resistance and a metal-like conductivity have actually been used and exhibited a certain degree of effect. For example, there has been proposed such a gasket product as shown in Fig. 1, in which a metal-plated fiber cloth 2 is wound round and bonded to a soft polyurethane foam which is such a rectangular parallelepipedal, three-dimensional network structure sheet 1 not plated with metal as shown in the same figure, then an adhesive layer 3 is formed on the whole or a part of the cloth surface, and a release paper 4 is laminated to the surface of the adhesive layer 3.

However, since such a gasket product is produced by a method applying an adhesive to a metal-plated fiber cloth and winding it around a rectangular parallelepipdal, mechanically pre-slit polyurethane foam, not only much labor is required but also there eventually arises the problem that the manufacturing cost is high.

The document EP-A-0 917 419 is disclosing a conductive material suitable as a gasket.

Objects of the Invention

The present invention has been accomplished in view of the present situation mentioned above and it is an object of the invention to provide an electromagnetic wave shielding gasket material capable of being mass-produced without going through such complicated manufacturing process as in the conventional like method and which is less expensive, uniform in quality, highly reliable, and superior in shielding effect.

Summary of the Invention

Having made studies earnestly for solving the above-mentioned problems, the present inventors accomplished the present invention.

According to the present invention, in the first aspect thereof, there is provided a gasket material for shielding electromagnetic waves, which gasket material is constituted by a metallized laminate, the metallized laminate being obtained by laminating and bonding a fiber cloth sheet and a three-dimensional network structure to each other and metallizing the resulting laminate, the three-dimensional network structure being constituted by a hollow framework having an average percentage of voids in the range from 95.0% to 99.9% and an internal surface area of 40 to 150 $cm^2/cm^3$, the three-dimensional network structure having deposited thereon a metal in an amount of 0.02 to 0.1 $g/cm^3$.

According to the present invention, in the second aspect thereof, there is provided a method for producing a gasket material for shielding electromagnetic waves, which method comprises laminating and bonding a three-dimensional net structure and a fiber cloth sheet to each other, the three-dimensional network structure being constituted by a hollow framework having an average percentage of voids in the range from 95.0% to 99.9% and an internal surface area of 40 to 150 $cm^2/cm^3$, and subsequently plating the whole of the resulting laminate sheet with a metal, such that the three - dimensional network structure has deposited thereon a metal in an amount of 0.02 to 0.1 $g/cm^3$.

Brief Description of the Drawings

Fig. 1 is a perspective view showing schematically a conventional gasket material for shielding electromagnetic waves;

Fig. 2 is a perspective view showing schematically a gasket material for shielding electromagnetic waves according to the present invention, the gasket material comprising a three-layer laminate and an adhesive layer, the three-layer laminate being composed of a three-dimensional network structure and fiber cloth sheets formed on both sides of the three-dimensional network structure, the adhesive layer being formed on a cloth sheet surface;

Fig. 3 is a perspective view showing schematically a gasket material for shielding electromagnetic waves according to the present invention, the gasket material comprising a two-layer laminate and an adhesive layer, the three-layer laminate being composed of a three-dimensional network structure and a fiber cloth sheet formed on one side of the three-dimensional network structure, the adhesive layer being formed on a cloth sheet surface;

Fig. 4 is a sectional view showing schematically a gasket material for shielding electromagnetic waves according to the present invention, the gasket material having a three-layer structure composed of a three-dimensional network structure and fiber cloth sheets formed on both sides of the three-dimensional network structure

Fig. 5 is a sectional view showing schematically a gasket material for shielding electromagnetic waves according to the present invention, the gasket material having a two-layer structure composed of a three-dimensional network structure and a fiber cloth sheet formed on one side of the three-dimensional network structure;

Fig. 6 is a sectional view showing schematically a gasket material for shielding electromagnetic waves according to the present invention wherein an adhesive is applied partially to a fiber cloth sheet surface shown in Fig. 4 with a release paper disposed on the adhesive layer;

Fig. 7 is a sectional view showing schematically a gasket material for shielding electromagnetic waves according to the present invention wherein an adhesive is applied partially to a fiber cloth sheet surface shown in Fig. 5 with a release paper disposed on the adhesive layer;

Fig. 8 is a sectional view showing schematically a gasket material for shielding electromagnetic waves according to the present invention wherein a conductive adhesive is applied to the whole surface of the fiber cloth sheet shown in Fig. 5;

Fig. 9 is a perspective view showing schematically a partially cut state of a gasket material for shielding electromagnetic waves, the gasket material being constituted by the gasket material of Fig. 8 with a release paper disposed on the conductive adhesive layer; and

Fig. 10 is a perspective view showing schematically a partially cut state of a gasket material for shielding electromagnetic waves, the gasket material being constituted by the gasket material of Fig. 7 with a release paper disposed on the partially applied adhesive layers.

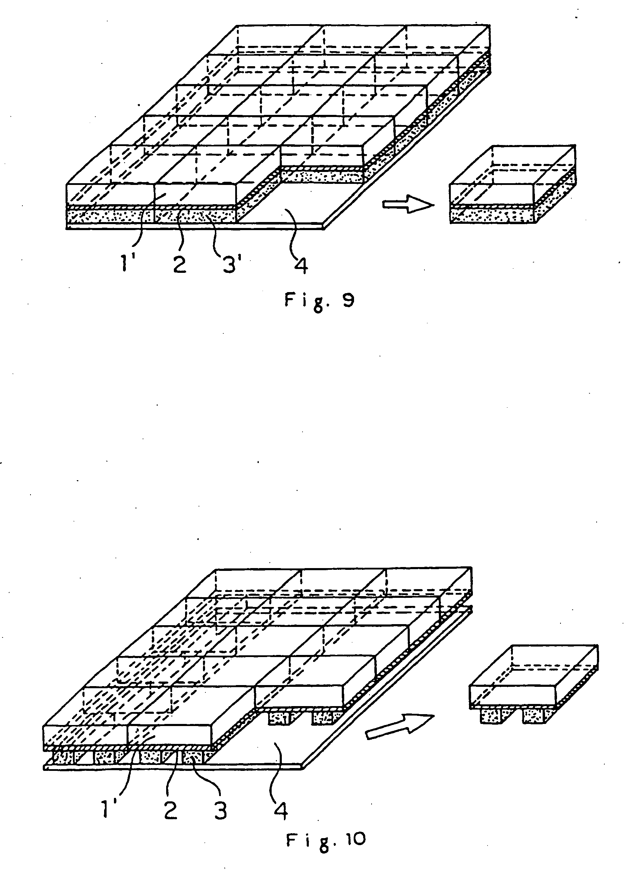

Figs. 9 and 10 are each for explaining a partially cut state, so in both figures, how to show structural portions is simplified and different from the other figures.

In the drawings, the reference numeral 1 denotes a three-dimensional net structure sheet not plated with a metal, numeral 1' denotes a three-dimensional network structure sheet plated with a metal, numeral 2 denotes a metal-plated fiber cloth, numeral 3 denotes an adhesive layer, numeral 3' denotes a conductive adhesive layer, numeral 4 denotes a release paper, and numeral 5 denotes a metal-plated fiber cloth sheet.

Preferred Embodiments

A conductive material suitable as a gasket material for shielding electromagnetic waves according to the present invention has typically such a sectional structure as shown in Fig. 4 or Fig. 5. Further, as shown in Figs, 2, 3 and 6 to 8, an adhesive layer 3 covered with a release paper 4 is formed on the whole or a part of an outer surface of a metallized laminate to constitute a gasket material for shielding electromagnetic waves. Moreover, a fiber cloth sheet and a three-dimensional network structure are laminated and bonded to each other in advance, the resulting laminate is then plated with a metal, an adhesive is applied to the whole or a part of an outer surface of the metal-plated laminate, and thereafter the adhesive layer thus formed is covered with release paper, to constitute a gasket material for shielding electromagnetic waves.

Fig. 2 is a perspective view showing an example of a cut form into a predetermined size of the electromagnetic wave shielding gasket material illustrated in Fig. 6, and Fig. 3 is a perspective view showing an example of a like cut form of the electromagnetic wave shielding gasket material illustrated in Fig. 7.

As examples of the fiber cloth used in the present invention there are mentioned woven, non-woven, and knitted fabrics, of which knitted and non-woven fabrics are preferred. Elastic ones are preferred. Particularly, those having a breaking elongation of 90% to 250% are preferred. If the elongation is lower than 90%, the fiber cloth concerned is apt to be wrinkled when the gasket material is attached to a housing or the like. If the elongation exceeds 250%, the fiber cloth concerned becomes thick and heavy.

The weight of the fiber cloth is preferably in the range of 10 to 100 $g/m^2$. If the weight is lower than 10 $g/m^2$, the strength of the fiber cloth concerned becomes lower and there is a fear that the fiber cloth may wear and be deteriorated in breaking strength. If the weight exceeds 100 $g/m^2$, it is likely that the fiber cloth may become thicker. As an example of a fiber cloth which satisfies the conditions described above there is mentioned a plain knit fabric, which is thin and flexible and is therefore preferable.

As the fiber which constitutes the fiber cloth used in the invention there may be used any of organic fibers, i.e., chemical fibers such as synthetic fibers, semi-synthetic fibers and regenerated fibers, and natural fibers such as vegetable fibers and animal fibers. Particularly, such synthetic fibers as polyamide fibers, polyester fibers, and acrylic fibers are preferred, with polyester (polyethylene terephthalate) fibers being most preferred. For example, a multi-filament consisting of filaments of 0.11 to 5.56 decitex is more preferable.

For ensuring the deposit of metal on the fiber cloth sheet it is desirable that impurities such as a sizing agent, oil, and dust adhered to the surface of the fiber cloth sheet be completely removed beforehand by a scouring process. As the three-dimensional network structure used in the present invention it is preferable to use a soft foam sheet of a three-dimensional network structure which comprises open cells substantially having no cell membrane and superior in compression stability. As examples of three-dimensional network structures having such characteristics are mentioned polyethylene foam, polypropylene foam, polyvinyl chloride foam, polyurethane foam, polyimide foam, and polybutadiene foam, with polyester-, polyether-, or polycarbonate-based polyurethane foams being preferred. Above all, polyether-based polyurethane foams are preferred in point of durability and cost.

The three-dimensional network structure used in the present invention has an average percentage of voids in the range from 95.0% to 99.9% and an internal surface area of 40 to 150 $cm^2/cm^3$. If the average percentage of voids is less than 95%, texture is hard, intra-foam voids are small, a plating solution is difficult to sufficiently soak into the interior of the foam concerned, thus making it difficult to effect uniform plating to the interior of the foam, and there is a fear that shieldability may be deteriorated. If the amount of a plating metal is increased for the improvement of shieldability, the plated layer thickness will become larger and hence the plated metal becomes easier to come off. If the average percentage of voids exceeds 99.9%, it may become difficult to produce a uniform three-dimensional network structure or the three-dimensional network structure obtained may be deteriorated in morphological stability or in durability.

The average percentage of voids is represented by the following equation (1) in which the volume $V_2$ of resin in a certain volume $V_1$ of foam is subtracted from the volume $V_1$, the difference obtained is divided by the certain volume $V_1$, and the quotient obtained is represented in terms of percentage:

$$\text{Average percentage of voids (\%)}$$
$$= (V_1 - V_2)/V_1 \times 100 \quad \ldots (1)$$

If the internal surface area is less than 40 $cm^2/cm^3$, the thickness of a metallic layer formed in the interior of the three-dimensional network structure for exhibiting the shielding performance becomes larger. This may result in that the electromagnetic wave shielding gasket concerned becomes less flexible or the metallic layer becomes easier to come off. If the internal surface area exceeds 150 $cm^2/cm^3$, the productivity of the three-dimensional network structure may be deteriorated.

For example, the internal surface area can be determined in accordance with the following way of thinking.

In the three-dimensional network structure, each cell is assumed to be in the shape of a regular dodecahedron having a one-side length of a and a cell frame is assumed to be a regular triangular prism having a one-side length of b and a height of a. In this case, the cell surface area, s, is represented by s = 30ab. Since the volume V of one cell is:

$$V = (15 + 7\sqrt{5})a^3/4$$

the number of cells, N, per unit volume is:

$$N = 1/V = 4/(15 + 7\sqrt{5})a^3$$

Thus, the surface area S per unit volume is represented as follows:

$$S = s \cdot N = 30ab(4/(15 + 7\sqrt{5})a^3) = 120b/((15 + 7\sqrt{5})a^2)$$

A sheet thickness of the three-dimensional structure differs depending on, for example, the purpose of use and the place of use, but is usually in the range of 0.5 to 5 mm.

It is desirable that a deterioration inhibitor be added to a foam easy to be deteriorated such as a polyether-based urethane foam. As examples of deterioration preventing agents employable in the invention there are mentioned hindered amine-, amine-, and phenol-based deterioration preventing agents. The amount thereof is in the range of 0.005% to 10%, preferably 0.05% to 1%, of the amount of the resin used for foam formation.

As the laminate there may be used a suitable laminate, for example, a laminate of a two-layer structure comprising the three-dimensional network structure and a fiber cloth sheet laminated to one side of the three-dimensional network structure or a laminate of a three-layer structure comprising the three-dimensional network structure and fiber cloth sheets laminated to both sides of the three-dimensional network structure. A four- or more-layer laminate is also employable as necessary.

The laminate of the fiber cloth sheet and the three-dimensional network structure can be obtained, for example, by a method wherein an adhesive is applied to the surface of one of the fiber cloth sheet and the three-dimensional network structure and thereafter the other is laminated to the adhesive-coated surface or by a heat-melting method wherein the surface of the three-dimensional network structure is melted directly with a flame of gas and thereafter the fiber cloth sheet is laminated and bonded to the thus-melted surface. But the latter method using heat-melting for bonding is recommended in order to ensure a satisfactory conductivity of the bonded portion between the fiber cloth sheet and the three-dimensional network structure when the laminate is subjected to metal plating. In this case, it is preferable that the flame-melting of the three-dimensional network structure be done to a depth of about 0.3 to 1 mm from the surface. If the melting depth is less than 0. 3 mm, a satisfactory bonding strength will not be obtained, and a melting depth exceeding 1 mm would lead to an increase of the manufacturing cost. When the aforesaid laminate is plated with a metal, not only the interior of the fiber cloth sheet and the interior of the three-dimensional network structure but also the interior of the melted layer portion of the three-dimensional network structure is metal-plated, affording a good conductivity of the bonded portion between the fiber cloth sheet and the three-dimensional network structure.

The laminate can be metallized by subjecting the laminate to pretreatments such as the application of catalyzing and activating prior to the regular plating process and thereafter plating it with a desired metal, e.g., Ag, Ni, Cu, Au, or Cu+Ni, by electroless plating and/or electroplating.

The thickness of the metal-plated layer formed on the laminate is preferably in the range of 0.01 to 2 $\mu$m. If the film thickness is smaller than 0.01 $\mu$m, a satisfactory shielding effect will not be obtained, and even if the thickness is set larger than 2 $\mu$m, not only a further improvement of shieldability will not be attained, but also a hard texture will result and there is a fear that the plated metal may become easier to come off.

In order to facilitate using the thus-plated laminate as an electromagnetic wave shielding gasket material, an adhesive may be applied to one side of the laminate, whereby the gasket material can be adhered to a housing or the like in a simple manner.

As the adhesive there may be used a conventional synthetic resin adhesive. Preferred examples are rubber adhesives, including natural rubber and synthetic rubber, acrylic adhesives such as acrylic ester copolymers, silicone adhesives such as silicone rubber and resin, and vinyl adhesives such as vinyl ether polymers, with acrylic adhesives being preferred. Adhesives which have electroconductivity are more preferable.

The adhesive may be applied partially to the laminate, for example, it may be applied as dots to the laminate by means of a gravure coater or may be applied as stripes to the laminate by means of a printer. There also may be adopted a method wherein the adhesive is applied to the whole surface of the laminate. The laminate thus coated with the adhesive is then dried, allowing the solvent contained therein to evaporate, and thereafter a release paper is laminated to the surface of the adhesive layer. Alternatively, the adhesive may be applied to the release paper side, followed by lamination in the same manner as above.

Particularly, the electromagnetic wave shielding gasket material with a conductive adhesive applied to the whole surface thereof affords a uniform adherence and a sufficient conductivity between it and an adhered object whichever portion thereof may be cut. Thus, such a gasket material is a highly reliable product. Although the manufacturing cost increases, but the coating method is easy. Besides, when slit into a desired width of strip so as to match the final use of the gasket material in question, the versatility of the material is further improved.

The electromagnetic wave shielding gasket material of the present invention can be produced in an extremely easy, inexpensive and quality-stable manner. The manual operating applying an adhesive to a metallized cloth and winding it around a pre-formed, rectangular parallelepipedal urethane foam is omitted, but this notwithstanding, the same performance as in the case of going through such manual operation is exhibited. With the metal-plated three-dimensional network structure alone, there arises the problem related to wear, but by laminating the fiber cloth sheet thereto it is possible to suppress the deterioration of shieldability and the danger of shorting in an electronic device which are caused by wear and metal exfoliation.

Further, even after the resulting product is slit into a small width of strip, a sufficient strength in its longitudinal direction is ensured and it becomes possible to perform a continuous work in all of the manufacturing steps.

Examples

The following examples are given for illustration of the present invention, in which the following measuring methods were used.

1. Surface Electric Resistance ($\Omega/\square$)

Both longitudinal ends of a test piece 100 mm wide by 120 mm long (one point each in the longitudinal and transverse directions) are sandwiched in between copper electrodes at an interval of 100 mm and an electric resistance value between the electrodes is measured.

2. Volume Resistance Value ($\Omega$)

A test piece 100 mm long by 100 mm wide is sandwiched in between copper electrodes each 100 mm long by 100 mm wide from above and below in the thickness direction of the text piece and a load of 30 g//cm$^2$ is imposed on the test piece. In this state, an electric resistance value between the electrodes is measured.

3. Electromagnetic wave shielding effect (dB)

A test piece is mounted between transmitting and receiving antennas in a shield box and the strength of a received electric field is measured and an attenuation factor (dB) is determined from the ratio to the intensity obtained in the absence of the test piece.

$$\text{(Shielding effect)} = 20 \log [\text{Field strength with shielding material/Field strength without shielding material}] \text{ (dB)}$$

4. Foam Strength

A foam sample is worn under the conditions of 500 g and 100 strokes with use of an abrasive machine in accordance with the method of a Gakushin abrasion machine, and the state of wear at a central part of the sample is checked visually.

　○ little wear
　X worn and shaved

5. Metal Exfoliation

A sample 1 cm wide by 15 cm long is compressed with a roller of 2.0 kg and the state of metal exfoliation is checked visually.

　○ little exfoliation of metal
　X metal powder exfoliation in a large amount

Example 1

A spun bonded non-woven cloth (weight: 50 g/m$^2$, average thickness: 240 $\mu$m) composed of polyester filaments (monofilament size: 2.2 decitex) was heat-melted to one side of a polyether-based soft polyurethane foam having a thickness of 1.5 mm, an average voids percentage of 99.5% and an average internal surface area of 45 cm$^2$/cm$^3$. Further, a plain knit fabric using a 55.6 decitex 24-filament polyester yarn and having course 54 pcs./inch (21.3 pcs./cm), wale 44 pcs./inch, and a breaking elongation of 230% was heat-melted to the other side of the polyurethane foam to afford a 1.4 mm thick three-layer laminate.

After subsequent scouring, the laminate was dipped 2 minutes in an aqueous solution containing 0.3 g/L of palladium chloride, 30 g/L of stannous chloride and 300 ml/L of 36% hydrochloric acid and was then washed with water. The laminate was then dipped in an aqueous borofluoric acid solution with an acid concentration of 0.1N at 30°C for 5 minutes, followed by water-washing.

The laminate was further dipped in an electroless copper plating solution of pH 12 comprising 7.5 g/L of copper sulfate, 30 ml/L of 37% formalin and 85 g/L of Rochelle salt at 40°C for 5 minutes, allowing 0.018 g/cm$^3$ of copper to be precipitated, followed by water-washing.

Subsequently, the laminate was dipped in an electrolytic nickel plating solution of pH 3.7 comprising 300 g/L of nickel sulfamate, 30 g/L of boric acid, and 15 g/L of nickel chloride at a current density of 5A/dm$^2$ and at 35°C for 10 minutes, allowing 0.015 g/cm$^3$ of nickel to be precipitated, followed by water-washing.

As a result there was obtained an electromagnetic wave shielding gasket material in which the fiber cloth and the foam were uniformly plated in both interior and surface and with a metallic layer of 0.033 g/cm$^3$ laminated to the foam. The performance thereof is shown in Table 1.

Example 2

A spun bonded non-woven cloth (weight: 50 g/m$^2$, average thickness: 240 $\mu$m) composed of polyester filaments (monofilament size: 2.2 decitex) was heat-melted to both sides of a polyether-based soft polyurethane foam having a thickness of 1.5 mm, an average voids percentage of 99.5 and an average internal surface area of 45 cm$^2$/cm$^3$ to afford a three-layer composite having a thickness of 1.4 mm.

After subsequent scouring, the composite was dipped 2 minutes in an aqueous solution containing 0.3 g/L of palladium chloride, 30 g/L of stannous chloride and 300 ml/L of 36% hydrochloric acid and was then washed with water. The composite was then dipped in an aqueous borofluoric acid solution with an acid concentration of 0.1N at 30°C for 5 minutes, followed by water-washing.

Further, the composite was dipped in an electroless copper plating solution comprising 7.5 g/L of copper sulfate, 30 ml/L of formalin and 85 g/L of Rochelle salt at 40°C for 5 minutes, allowing 0.018 g/cm$^3$ of copper to be precipitated.

Subsequently, the composite was dipped in an electrolytic nickel plating solution of pH 3.7 containing 300 g/L of nickel sulfamate, 30 g/L of boric acid and 15 g/L of nickel chloride at a current density of 5 A/dm$^2$ and at 35°C for 10 minutes, allowing 0.015 g/cm$^3$ of nickel to be precipitated.

As a result there was obtained an electromagnetic wave shielding gasket material in which the fiber cloth and the foam were uniformly plated in both interior and surface and with 0.033 g/cm$^3$ of a metallic layer laminated to the foam.

Comparative Example 1

A spun bonded non-woven cloth (weight: 50 g/m$^2$, average thickness: 240 $\mu$m) composed of polyester filaments (monofilament denier: 2.0 d) was heat-melted to one side of a polyether-based soft polyurethane foam having a thickness of 1.5 mm, an average voids percentage of 99.5% and an average internal surface area of 18 cm$^2$/cm$^3$.

Further, a plain knit fabric using a 55.6 decitex 24-filament polyester yarn and having course 54 pcs./inch (136,8 pcs./cm), wale 44 pcs./inch, and a breaking elongation of 230% was het-melted to the other side of the polyurethane foam to afford a 1.4 mm thick three-layer laminate.

After subsequent scouring, the laminate was dipped in an aqueous borofluoric acid solution with an acid concentration of 0.1N at 30°C for 5 minutes and was then washed with water.

Further, the laminate was dipped in an electroless copper plating solution of pH 12 comprsiing 7.5 g/L of copper sulfate, 30 ml/L of formalin and 85 g/L of Rochelle salt at 40°C for 10 minutes, allowing 0.018 g/cm$^3$ of copper to be precipitated, followed by water-washing.

Subsequently, the laminate was dipped in an electrolytic nickel plating solution of pH 3.7 containing 300 g/L of nickel sulfamate, 30 g/L of boric acid and 15 g/L of nickel chloride at a current density of 5 A/dm$^2$ and at 35°C for 20 minutes, allowing 0.015 g/cm$^3$ of nickel to be precipitated, followed by water-washing.

As a result there was obtained an elctromagnetic wave shielding gasket material in which the fiber cloth and the foam were plated in both interior and surface with a metallic layer of 0.033 g/cm$^3$ laminated to the foam. The performance thereof is shown in Table 1.

Comparative Example 2

A spun bonded non-woven cloth composed of polyester filaments was heat-melted to both sides of a polyether-based soft polyurethane foam having a thickness of 1.5 mm, an average voids percentage of 99.5% and an average internal surface area of 220 $cm^2/cm^3$.
Further, a plain knit fabric using a 55.6 decitex 24-filament polyester yarn and having course 54 pcs./inch (136,8 pcs./cm), wale 44 pcs./inch, and a breaking elongationof 230% was heat-melted to the other side of the polyurethane foam to afford a 1.4 mm thick three-layer laminate.
After subsequent scouring, the laminate was dipped 2 minutes in an aqueous solution containing 0.3 g/L of palladium chloride, 30 g/L of stannous chloride and 300 ml/L of 36% hydrochloric acid and was then washed with water. Thereafter, the laminate was dipped in an aqueous borofluoric acid solution with an acid concentration of 0.1N at 30˚C for 5 minutes, followed by water-washing.
Further, the laminate was dipped in an electroless copper plating solution of pH 12 comprising 7.5 g/L of copper sulfate, 30 ml/L of 37% formalin and 85 g/L of Rochelle salt at 40˚C for 5 minutes, allowing 0.018 $g/cm^3$ of copper to be precipitated, followed by water-washing.
Subsequently, the laminate was dipped in an electrolytic nickel plating solution of pH 3.7 containing 300 g/L of nickel sulfamate, 30 g/L of boric acid and 15 g/L of nickel chloride at a current density of 5A/$dm^2$ and at 35˚C for 10 minutes, allowing 0.015 $g/cm^3$ of nickel to be precipitated, followed by water-washing.
In the resulting product, the surfaces of the fiber cloth and the foam were plated uniformly, but the interior of the foam was uneven in plating. An average amount of metal deposited was 0.033 $g/cm^3$. The performance of the product is set out in Table 1.

Comparative Example 3

A spun bonded non-woven cloth (weight: 50 $g/m^2$, average thickness: 240 $\mu$m) composed of polyester filaments (monofilament size: 2.2 decitex) was heat-melted to one side of a polyether-based soft polyurethane foam having a thickness of 1.5 mm, an average voids percentage of 80.0% and an average internal surface area of 45 $cm^2/cm^3$. Further, a plain knit fabric using a 55.6 decitex 24-filament polyester yarn and having course 54 pcs./inch (21.3 pcs./cm), wale 44 pcs./inch, and a breaking elongation of 230% was heat-melted to the other side of the polyurethane foam to afford a 1.4 mm thick three-layer laminate.
After subsequent scouring, the laminate was dipped 2 minutes in an aqueous solution containing 0.3 g/L of palladium chloride, 30 g/L of stannous chloride and 300 ml/L of 36% hycrochloric acid and was then washed with water. Thereafter, the laminate was dipped in an aqueous borofluoric acid solution with an acid concentration of 0.1N at 30˚C for 5 minutes, followed by water-washing.
Further, the laminate was dipped in an electroless copper plating solution of pH 12 comprising 7.5 g/L of copper sulfate, 30 ml/L of 37% formalin and 85 g/L of Rochelle salt at 40˚C for 5 minutes , allowing 0.018 $g/cm^3$ of copper to be precipitated, followed by water-washing.
Subsequently, the laminate was dipped an electrolytic nickel plating solution of pH 3.7 containing 300 g/L of nickel sulfamate, 30 g/L of boric acid and 15 g/L of nickel chloride at a current density of 5A/$dm^2$ and at 35˚C for 10 minutes, allowing 0.015 $g/cm^3$ of nickel to be precipitated, followed by water-washing. It turned out that a metallic film in an amount of 0.033 $g/cm^2$ was applied to the laminate.
As a result, the fiber cloth and the foam were plated in both interior and surface. The performance of the product obtained is set out in Table 1.

Table 1

| | Average Voids Percentage (%) | Internal Surface Area (cm²/cm²) | Fiber Cloth Sheet | Surface Resistance Value Longitudinal/Transverse (Ω/□) | Volume Resistance Value (Ω) | Shielding effect (dB) | | | Foam Producibility | Metal Exfoliation |
|---|---|---|---|---|---|---|---|---|---|---|
| | | | | | | 10MHz | 100HHz | 1GHz | | |
| Example 1 | 99.5 | 45 | PET Non-Woven fabric PET Plain Knit fabric | 0.10/0.15 | 0.01 | 83 | 94 | 106 | ○ | ○ |
| Example 2 | 99.5 | 45 | PET Non-Woven fabric PET Non-Woven fabric | 0.10/0.15 | 0.01 | 84 | 94 | 106 | ○ | ○ |
| Comparative Example 1 | 99.5 | 18 | PET Non-Woven fabric PET Plain Knit fabric | 0.50/0.80 | 0.05 | 80 | 85 | 90 | ○ | × |
| Comparative Example 2 | 99.5 | 220 | PET Non-Woven fabric PET Plain Knit fabric | 0.05/0.05 | 0.01 | 90 | 100 | 110 | × | ○ |
| Comparative Example 3 | 80.0 | 45 | PET Non-Woven fabric PET Plain knit fabric | 0.50/0.80 | 0.05 | 80 | 85 | 90 | ○ | × |

**Claims**

1. A gasket material for shielding electromagnetic waves, constituted by a metallized laminate, said metallized laminate being obtained by laminating and bonding a fiber cloth sheet and a three-dimensional network structure to each other and metallizing the resulting laminate, said three-dimensional network structure being constituted by a hollow framework having an average percentage of voids in the range from 95.0% to 99.9% and an internal surface area of 40 to 150 cm$^2$/cm$^3$, the three-dimensional network structure having deposited thereon a metal in an amount of 0.02 to 0.1 g/cm$^3$.

2. A gasket material for shielding electromagnetic waves according to claim 1, wherein said three-dimensional network structure and said fiber cloth sheet are bonded

3. A gasket material for shielding electromagnetic waves according to claim 1 or 2, wherein said three-dimensional network structure is a soft polyurethane foam.

4. A gasket material for shielding electromagnetic waves according to claim 3, wherein said polyurethane foam is a polyether-based polyurethane foam.

5. A gasket material for shielding electromagnetic waves according to claim 3 or 4, wherein a urethane deterioration preventing agent is added to said polyurethane foam.

6. A gasket material for shielding electromagnetic waves according to any of claims 1 to 5, wherein said fiber cloth sheet comprises a non-woven cloth and a knitted fabric.

7. A gasket material for shielding electromagnetic waves according to claim 6, wherein said knitted fabric is a plain knit fabric having an elongation of 90% to 250% (JIS L1096).

8. A gasket material for shielding electromagnetic waves according to any of claims 1 to 7, wherein an adhesive layer is formed on at least one side of said fiber cloth sheet and, where required, release paper is laminated onto said adhesive layer.

9. A method for producing a gasket material for shielding electromagnetic waves, which method comprises laminating and bonding a three-dimensional network structure and a fiber cloth sheet to each other, said three-dimensional network structure being constituted by a hollow framework having an average percentage of voids in the range from 95.0% to 99.9% and an internal surface area of 40 to 150 cm$^2$/cm$^3$, and subsequently plating the whole of the resulting laminate sheet with a metal such that the three-dimensional network structure has deposited thereon a metal in an amount of 0.02 to 0.1 g/cm$^3$.

10. A method according to claim 9, wherein said three-dimensional network structure and said fiber cloth sheet are bonded together by heat-melting at least a part of a surface of the three-dimensional network structure.

11. A method according to claim 9 or claim 10, including a further step of applying an adhesive to one side of the metal-plated laminate and covering the adhesive with a release paper to afford the gasket material with the release paper.

12. A method according to claim 11, including a further step of cutting the other laminated and bonded portion than the release paper portion of the gasket material with the release paper into small sections each having a predetermined certain area.

**Patentansprüche**

1. Dichtungsmaterial zur Abschirmung elektromagnetischer Wellen, ausgebildet durch ein metallisiertes Laminat, wobei das metallisierte Laminat erhalten wird, indem ein Gewebetuch und eine dreidimensionale Netzwerkstruktur miteinander beschichtet und gebondet werden und das resultierende Laminat metallisiert wird, wobei die dreidimensionale Netzwerkstruktur durch einen hohlen Rahmen ausgebildet wird, der einen mittleren Prozentsatz von Hohlräumen bzw. Lücken in dem Bereich von 95,0% bis 99,9% aufweist und einen inneren Oberflächenbereich von 40 bis 150 cm$^2$/cm$^3$, wobei die dreidimensionale Netzwerkstruktur hierauf ein Metall in einer Menge von 0,02 bis 0,1 g/cm$^3$ abgeschieden hat.

2. Dichtungsmaterial zur Abschirmung elektromagnetischer Wellen nach Anspruch 1, wobei die dreidimensionale Netzwerkstruktur und das Gewebetuch gebondet sind.

3. Dichtungsmaterial zur Abschirmung elektromagnetischer Wellen nach Anspruch 1 oder 2, wobei die dreidimensionale Netzwerkstruktur ein weicher Polyurethanschaum ist.

4. Dichtungsmaterial zur Abschirmung elektromagnetischer Wellen nach Anspruch 3, wobei der Polyurethanschaum ein Polyester basierter Polyurethanschaum ist.

5. Dichtungsmaterial zur Abschirmung elektromagnetischer Wellen nach Anspruch 3 oder 4, wobei dem Polyurethanschaum ein Agens zur Verhinderung einer Urethanalterung bzw. -schädigung zugegeben wird.

6. Dichtungsmaterial zur Abschirmung elektromagnetischer Wellen nach irgendeinem der Ansprüche 1 bis 5, wobei das Gewebetuch ein nicht-gewobenes Gewebe und eine Maschenware umfasst.

7. Dichtungsmaterial zur Abschirmung elektromagnetischer Wellen nach Anspruch 6, wobei die Maschenware eine einfache Maschenware ist, die eine Ausdehnung von 90% bis 250% (JIS L1096) aufweist.

8. Dichtungsmaterial zur Abschirmung elektromagnetischer Wellen nach irgendeinem der Ansprüche 1 bis 7, wobei eine adhäsive Schicht auf wenigstens einer Seite des Gewebetuchs ausgebildet ist, und, falls erforderlich, Silikonpapier auf der adhäsiven Schicht beschichtet ist.

9. Verfahren zur Herstellung eines Dichtungsmaterials zur Abschirmung elektromagnetischer Wellen, wobei das Verfahren das Beschichten und Bonden einer dreidimensionalen Netzwerkstruktur und eines Gewebetuchs miteinander umfasst, wobei die dreidimensionale Netzwerkstruktur aus einem hohlen Rahmen besteht, der einen mittleren Prozentsatz von Hohlräumen in dem Bereich von 95% bis 99,9% und einen inneren Oberflächenbereich von 40 bis 150 cm$^2$/cm$^3$ aufweist, und anschließend das Ganze des resultierenden Laminatblatt mit einem Metall metallisiert wird, sodass die dreidimensionale Netzwerkstruktur hierauf ein Metall in einer Menge von 0,02 bis 0,1 g/cm$^3$ abgeschieden hat.

10. Verfahren nach Anspruch 9, wobei die dreidimensionale Netzwerkstruktur und das Gewebetuch zusammengebondet werden, indem wenigstens ein Teil einer Oberfläche der dreidimensionalen Netzwerkstruktur Hitzegeschmolzen wird.

11. Verfahren nach Anspruch 9 oder 10, das einen weiteren Schritt des Aufbringens eines Haftmittels auf eine Seite des metallbeschichteten Laminats umfasst und das Haftmittel mit einem Silikonpapier abdeckt, um das Dichtungsmaterial mit dem Silikonpapier zu ermöglichen.

12. Verfahren nach Anspruch 11, das einen weiteren Schritt des Schneidens des anderen beschichteten und gebondeten Abschnitts als dem Silikonspapierabschnitt des Dichtungsmaterials mit dem Silikonpapier in kleine Abschnitte umfasst, wobei jeder einen vorbestimmten bestimmten Bereich aufweist.

**Revendications**

1. Matériau pour joint destiné au blindage contre les ondes électromagnétiques, constitué d'un stratifié métallisé, ledit stratifié métallisé étant obtenu en stratifiant et en liant l'une à l'autre une feuille de toile de fibres et une structure en réseau tridimensionnel et en métallisant le stratifié obtenu, ladite structure en réseau tridimensionnel étant constituée d'une ossature creuse ayant un pourcentage moyen de vides allant de 95,0 % à 99,9 % et une superficie de surface interne allant de 40 à 150 cm$^2$/cm$^3$, un métal, en une quantité allant de 0,02 à 0,1 g/cm$^3$, étant déposé sur la structure en réseau tridimensionnel.

2. Matériau pour joint destiné au blindage contre les ondes électromagnétiques selon la revendication 1, dans lequel ladite structure en réseau tridimensionnel et ladite feuille de toile de fibres sont liées.

3. Matériau pour joint destiné au blindage contre les ondes électromagnétiques selon la revendication 1 ou 2, dans lequel ladite structure en réseau tridimensionnel est une mousse de polyuréthane souple.

**4.** Matériau pour joint destiné au blindage contre les ondes électromagnétiques selon la revendication 3, dans lequel ladite mousse de polyuréthane est une mousse de polyuréthane à base de polyéther.

**5.** Matériau pour joint destiné au blindage contre les ondes électromagnétiques selon la revendication 3 ou 4, dans lequel un agent de prévention de la détérioration de l'uréthane est ajouté à ladite mousse de polyuréthane.

**6.** Matériau pour joint destiné au blindage contre les ondes électromagnétiques selon la revendication 1 à 5, dans lequel ladite feuille de toile de fibres comprend une toile non tissée et un tissu à maille.

**7.** Matériau pour joint destiné au blindage contre les ondes électromagnétiques selon la revendication 6, dans lequel ledit tissu à maille est un tissu à maille unie ayant une extensibilité allant de 90 % à 250 % (JIS L1096).

**8.** Matériau pour joint destiné au blindage contre les ondes électromagnétiques selon l'une quelconque des revendications 1 à 7, dans lequel une couche adhésive est formée sur au moins un côté de ladite feuille de toile de fibres et, si nécessaire, un papier anti-adhésif est stratifié sur ladite couche adhésive.

**9.** Procédé pour la production d'un matériau pour joint destiné au blindage contre les ondes électromagnétiques, lequel procédé comprend les étapes consistant à stratifier et à lier l'une à l'autre une structure en réseaux tridimensionnel et une feuille de toile de fibres, ladite structure en réseaux tridimensionnel étant constituée d'une ossature creuse ayant un pourcentage moyen de vides allant de 95,0 % à 99,9 % et une superficie de surface interne allant de 40 à 150 cm$^2$/cm$^3$, et ensuite à plaquer la totalité de la feuille stratifiée obtenue avec un métal, de sorte que la structure en réseau tridimensionnel a, déposée sur elle, un métal en une quantité allant de 0,02 à 0,1 g/cm$^3$.

**10.** Procédé selon la revendication 9, dans lequel ladite structure en réseau tridimensionnel et ladite feuille de toile de fibres sont liées ensemble par thermofusion d'au moins une partie d'une surface de la structure en réseau tridimensionnel.

**11.** Procédé selon la revendication 9 ou 10, comprenant une étape supplémentaire consistant à appliquer un adhésif sur un côté du stratifié plaqué au métal et à recouvrir l'adhésif d'un papier antiadhésif afin d'obtenir le matériau pour joint avec le papier antiadhésif.

**12.** Procédé selon la revendication 11, comprenant une étape supplémentaire consistant à découper la partie stratifiée et liée autre que la partie papier antiadhésif du matériau pour joint avec le papier antiadhésif en petites sections ayant chacune une certaine superficie prédéterminée.

Fig. 1

Fig. 2

Fig. 3

Fig. 4

Fig. 5

Fig. 6

Fig. 7

Fig. 8

Fig. 9

Fig. 10

**EP 1 235 473 B1**

**Patent documents cited in the description**

- EP 0917419 A